# FASCICULE DE BREVET EUROPEEN

(11) **EP 0 618 591 B1**
(45) Date de publication et mention de la délivrance du brevet: **02.01.1997**
(21) Numéro de dépôt: 94400709.5
(22) Date de dépôt: 31.03.1994
(51) Int. Cl.: G11C 16/06

(54) **Circuit intégré pour carte à mémoire et procédé de décomptage d'unités dans une carte à mémoire**
Integrierte Schaltung für Speicherkarte und Verfahren zum Abzählen der Einheiten in einer Speicherkarte
Integrated circuit for memory card and method for deducting units in a memory card

(30) Priorité: 01.04.1993 FR 9303836
(43) Date de publication de la demande: 05.10.1994
(73) Titulaire: GEMPLUS CARD INTERNATIONAL, F-13420 Gemenos (FR)
(72) Inventeur: Kowalski, Jacek Antoni, Cabinet Ballot-Schmit, F-75116 Paris (FR)
(74) Mandataire: Schmit, Christian Norbert Marie

(56) Documents cités:
- EP-A- 0 321 727
- EP-A- 0 519 847

## Description

L'invention concerne les cartes à puces, et plus spécialement celles qui servent de moyen de prépaiement pour décompter des unités au fur et à mesure de l'utilisation de biens ou services. L'invention n'est cependant pas limitée à cette utilisation de cartes à puces; elle concerne plus généralement des applications où il faut compter ou décompter des unités par le moyen d'une programmation de cellules de mémoire non volatile électriquement programmables et effaçables (mémoires EEPROM).

Dans les cartes à puces à microprocesseurs, appelées encore cartes asynchrones, les procédés de comptage sont efficaces, adaptables en fonction de l'application, et sécurisés contre les fraudes ou erreurs de manipulation. Mais dans les cartes sans microprocesseurs ou cartes synchrones (qui ont l'avantage d'être moins coûteuses), les procédés sont moins versatiles et moins sûrs.

Le principe de comptage qui semble aujourd'hui le mieux adapté aux cartes synchrones est le principe du boulier, qui permet, avec un petit nombre de cellules de mémoire EEPROM, de décompter un grand nombre d'unités. L'avantage de ce principe est sa facilité de réalisation donc son coût pas trop élevé.

Dans le comptage de type boulier, la mémoire est organisée en N zones de P cellules, en pratique N lignes de P cellules. Le nombre de cellules programmées dans une ligne représente un chiffre du nombre d'unités mémorisées, et le rang de la ligne représente le poids de ce chiffre; le poids affecté à une ligne est P fois le poids de la ligne de rang immédiatement inférieur. Le compte total d'unités est la somme des nombres de cellules programmées dans chaque ligne, ces nombres étant pondérés par le poids de la ligne respective.

Par exemple, avec une mémoire de trois lignes de huit cellules chacune, ayant respectivement x cellules, y cellules, et z cellules, programmées respectivement sur la première, la deuxième, et la troisième ligne de poids respectifs 8⁰, 8¹, et 8², c'est-à-dire 1, 8 et 64, le compte total d'unités représenté par la mémoire est : x + 8y + 64z. Cette mémoire de 24 cellules peut compter de O à 584 unités ou décompter de 584 à 0.

Conventionnellement, on considérera dans la suite que la cellule effacée est représentée par un "1" logique et la cellule programmée par un "0" logique, et on considérera en conséquence que la mémoire va servir à décompter des unités à partir d'un total initial plutôt qu'à les compter en incrémentant ce total. L'inverse serait bien sûr obtenu en adoptant des conventions inverses.

Supposons par exemple, en reprenant le cas d'une mémoire à trois lignes de huit cellules, que le compte initial soit 194 (exprimé en nombre décimal), c'est-à-dire que z=3, y=0, x=2.

Le motif initial de la mémoire est :

| | | | |
|---|---|---|---|
| 11100000 | z=3 | | 3x64 = 192 |
| 00000000 | y=0 | | +0x8 = 0 |
| 11000000 | x=2 | | +2x1 = 2 |
| | | Total : | 194 |

Le décomptage d'une unité va consister à programmer à zéro une cellule effacée de la dernière ligne, faisant passer x à 1 et le compte à 191; pour décompter encore une unité on programme une autre cellule de la dernière ligne, faisant passer x à 0 et le compte à 192.

Le motif des 24 cellules de la mémoire devient alors :
11100000
00000000
00000000 compte : 192

Là le problème devient plus difficile puisqu'on ne peut plus programmer de cellules ayant un poids unitaire.

Par conséquent, on effectue une séquence intermédiaire qui est le propre du comptage de type boulier et qui consiste dans cet exemple à :
- a./ programmer à 0 une cellule à 1 de la première ligne (en fait la première cellule à 1 qu'on rencontre en remontant de la dernière ligne vers la première; ici c'est une cellule de la première ligne puisqu'il n'y en a pas dans la deuxième); le motif devient :
   11000000
   00000000
   00000000
- b./ effacer toute la deuxième ligne (c'est-à-dire effacer toute la ligne qui suit une ligne dans laquelle on fait une programmation); le motif devient :
   11000000
   11111111
   00000000 le compte est bien 192 comme avant;

Mais on ne peut toujours pas décompter unité par unité puisqu'il n'y a pas de cellule effacée sur la ligne de poids faible; on refait alors la même séquence a puis b que ci-dessus :
- a'./ programmer à 0 la première cellule à 1 rencontrée en remontant de la dernière ligne vers la première; le motif devient :
   11000000
   11111110
   00000000
- b'./ effacer toute la ligne qui suit celle où on vient de faire une programmation; le motif devient :
   11000000
   11111110
   11111111 le compte est toujours 192;

Mais maintenant on peut décompter unité par unité en programmant successivement les cellules de la ligne de poids le plus faible.

Le principe du décomptage d'une unité consiste donc à exécuter la procédure récurrente suivante : rechercher dans la mémoire, en parcourant celle-ci dans l'ordre des poids croissants, une cellule effacée (à 1), programmer cette cellule (la mettre à 0), et, si elle n'appartient pas à la ligne de poids le plus faible, effacer (mettre à 1) toute la ligne de rang immédiatement inférieur et recommencer la procédure.

Mais, on s'est aperçu que cette procédure récurrente, bien qu'assez simple, pouvait avoir des inconvénients : si on reprend les motifs intermédiaires de la mémoire au cours des étapes a et a' de la récurrence, on s'aperçoit que le compte contenu dans la mémoire à la fin de ces étapes est respectivement 128 et 184 alors qu'il devrait être de 192 puisque ces étapes ne sont que des étapes intermédiaires effectuées alors qu'il n'y a pas encore eu de décomptage d'une unité.

Par conséquent, si par accident il y a coupure de courant pendant ces étapes, par exemple par arrachage de la carte hors de son lecteur, la mémoire va conserver un compte erroné, qui n'a rien à voir avec le compte réel.

On comprend que dans certaines applications ceci peut avoir des inconvénients importants. C'est le cas par exemple si le compte de la mémoire représente un crédit disponible pour le titulaire; une portion de ce crédit sera définitivement perdu. Dans d'autres applications, cela pourrait être le contraire; dans tous les cas, cette situation n'est pas souhaitable.

L'invention a pour but d'éviter cet inconvénient.

On propose selon l'invention d'adjoindre à chaque ligne de cellules de la mémoire non volatile (sauf la ligne de poids le plus faible) une cellule de mémoire non volatile auxiliaire qui est mise dans un premier état lors de la programmation d'une cellule de la ligne et qui est mise dans un second état lors de l'effacement de la ligne de rang immédiatement inférieur. Dans tout ce qui suit on appellera "programmation" le passage dans le premier état et "effacement" le passage dans le second état; les notions de programmation sont donc interchangeables et dépendent tout simplement de la convention d'usage; par exemple, dans une mémoire EEPROM, on appelle conventionnellement "effacement" le stockage d'électrons dans une grille flottante, mais l'invention est applicable même si on utilise une convention inverse.

Si la carte à mémoire subit un arrachage ou une coupure d'alimentation intempestive, entre la programmation d'une cellule de la ligne et l'effacement de la ligne suivante, elle conservera un bit d'information en mémoire dans la cellule auxiliaire. Lors de la réinsertion de la carte dans un lecteur, les cellules de mémoire auxiliaire seront explorées; la détection d'une cellule dans le second état signifiera qu'il y a eu interruption intempestive du fonctionnement entre les étapes a (programmation de cellule) et b (effacement de ligne) de la récurrence; de plus on saura quelle est la ligne concernée. On effacera alors la ligne de rang immédiatement inférieur avant toute étape ultérieure de décomptage.

Une solution comparable est décrite dans le document EP-A-0 519 847. Cependant, dans ce document, il est enseigné d'avoir autant de cellules auxiliaires que de cellules à décompter. Ceci entraîne des inconvénients de perte de place à la surface de la puce pour réaliser le décodage et l'accès à toutes ces cellules auxiliaires.

Par conséquent, l'invention concerne une carte à mémoire (et le circuit intégré d'une carte) destinée à mémoriser un compte d'unités, le circuit comprenant une mémoire non volatile organisée en réseau de N zones de P cellules avec des moyens de programmation sélective d'une cellule de rang i,j de la mémoire, i désignant le rang de la zone (i=1 à N) et j le rang de la cellule dans la zone (j=1 à P), et des moyens d'effacement sélectif de toutes les cellules d'une zone sélectionnée, le circuit étant caractérisé en ce qu'il comporte, associée à chaque zone de rang i, une seule cellule de mémoire auxiliaire non volatile et des moyens pour programmer cette cellule auxiliaire en même temps que n'importe quelle cellule de la zone de rang i et pour effacer cette cellule auxiliaire en même temps que sont effacées les cellules de la zone de rang i-1. Selon une réalisation avantageuse, le circuit intégré comporte un compteur d'adresse dont les sorties de poids fort servent à désigner une zone de rang i et dont les sorties de poids faible servent à désigner une cellule de rang j dans les zones; on prévoit alors qu'il y a des circuits commandés par les sorties de poids fort du compteur, ces circuits étant aptes à appliquer, lorsque la zone i est sélectionnée par le compteur, des potentiels de programmation à une cellule de la zone i et à la cellule auxiliaire associée de rang i, et aptes à appliquer, sans changer l'état du compteur, c'est-à-dire toujours lorsque la ligne i est sélectionnée, des potentiels d'effacement aux cellules de la zone de rang i-1 (i>1) et à la cellule auxiliaire de rang i.

Avec cette disposition, on verra qu'il devient très facile d'exécuter la procédure récurrente de décomptage, même avec un protocole de communication très simplifié entre la carte à mémoire et un lecteur de cartes dans laquelle elle est insérée. En effet, la plupart des protocoles de lecture de cartes à huit contacts prévoient un très petit nombre d'instructions possibles telles que : incrémentation du compteur, lecture de l'état d'une cellule désignée, programmation de la cellule désignée, effacement de la ligne. L'invention permet d'effectuer la procédure récurrente sans avoir à faire revenir le compteur en arrière malgré le fait qu'il doit effacer une ligne de rang i-1 après avoir programmé une ligne de rang i.

Les cellules de mémoire non volatiles et les cellules auxiliaires seront de préférence constituées par un ensemble en série d'un transistor de sélection et un transistor à grille flottante.

Comme on le verra, les grilles de commande des transistors à grille flottante de la zone de rang i-1 seront reliées à la grille de commande du transistor à grille flottante de la cellule auxiliaire de rang i. Les particularités de montage préférées selon l'invention seront détaillées plus loin.

Outre le circuit de carte à mémoire et la carte à mémoire correspondante, l'invention concerne aussi le procédé de décomptage d'unités dans une carte synchrone sous contrôle d'un lecteur de cartes.

Le procédé selon l'invention est défini par la revendication 8.

Le protocole de décomptage comportera de préférence les étapes préliminaires suivantes avant toute procédure de décomptage, à la mise sous tension de la carte à mémoire : recherche d'une cellule auxiliaire programmée, et si une cellule auxiliaire de rang i est trouvée à l'état programmé, effacement simultané de cette cellule de rang i ainsi que de toutes les cellules de la zone de rang immédiatement inférieur i-1.

Quant à la procédure récurrente, elle comprendra de préférence les étapes d'incrémentation du compteur de désignation de cellules, et lecture de l'état des cellules successives du réseau en commençant par la zone de rang le plus faible, jusqu'à trouver une cellule effacée, exécuter une étape de programmation de cette cellule sans incrémenter le compteur, puis, si la cellule désignée par le compteur n'appartient pas à la zone de poids le plus faible, effectuer une étape d'effacement sans changer l'état du compteur et recommencer la procédure récurrente.

D'autres caractéristiques et avantages de l'invention apparaîtront à la lecture de la description détaillée qui suit et qui est faite en référence aux dessins annexés dans lesquels :
- la figure 1 représente la mémoire selon l'invention;
- la figure 2 représente les diagrammes de potentiels appliqués pendant une instruction de programmation de cellule;
- la figure 3 représente les diagrammes de potentiels appliqués pendant une opération d'effacement de ligne;
- la figure 4 représente les diagrammes de potentiel au cours des étapes de lecture d'une cellule du réseau et d'une cellule auxiliaire.

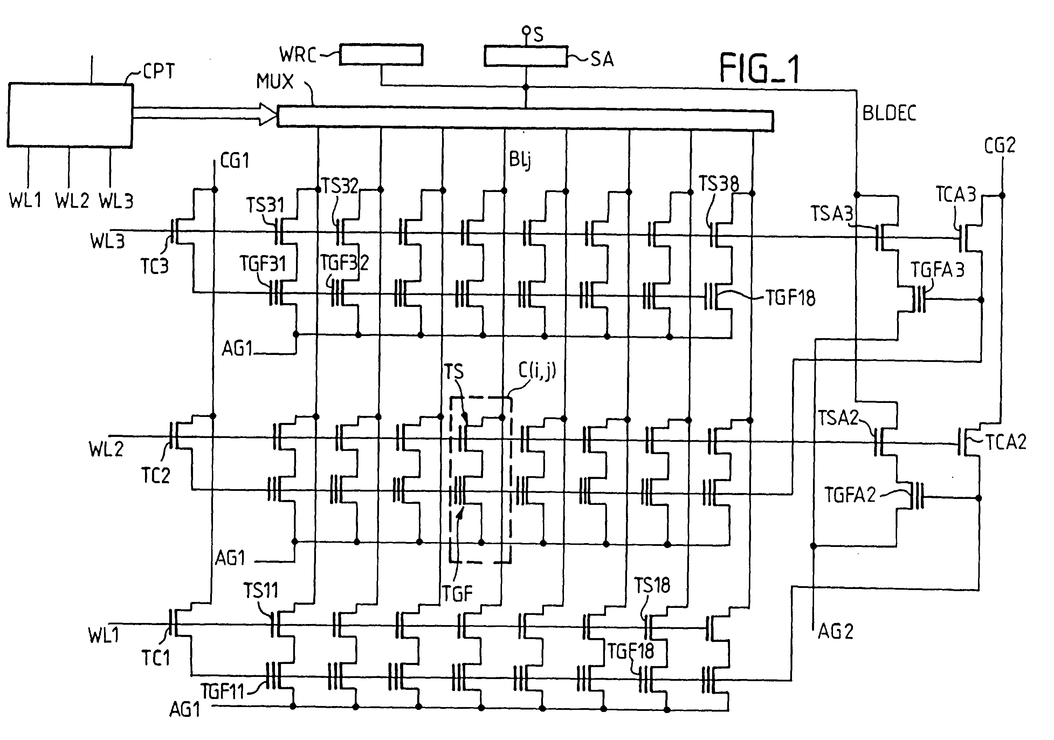

Sur la figure 1, on a représenté la mémoire dans l'exemple où les zones de mémoire représentant les poids respectifs des unités de compte sont des lignes de huit cellules (P=8), et où il y a trois lignes de poids croissants (N=3), celle du bas étant la ligne de poids le plus faible.

De préférence, chaque cellule de mémoire non volatile C(i,j)comporte un transistor de sélection TS et un transistor à grille flottante TGF. Les transistors sont repérés avec un indice de type ij, i représentant le numéro de la ligne en partant d'en bas (poids inférieur) et j le numéro de la colonne.

Le transistor à grille flottante TGF a sa source reliée à un conducteur AG1 qui est commun à toutes les cellules et qui peut être soit porté à la masse soit laissé flottant. Les grilles de commande de tous les transistors à grille flottante de la même ligne de rang i sont reliées ensemble à la source d'un transistor de commande de même rang i (TC1, TC2, TC3); la grille de ce transistor de commande TC1, TC2 ou TC3 est commandée par un conducteur de ligne de mot de rang i. Par exemple, pour la ligne 1 les grilles des transistors à grille flottante sont toutes reliées à la source d'un transistor de commande TC1 dont la grille est reliée à un conducteur de ligne de mot WL1.

Les transistors TC1, TC2, TC3 ont leur drain reliés à un conducteur commun CG1 qui sert à appliquer un potentiel de lecture, programmation ou effacement à la grille des transistors à grille flottante d'une ligne sélectionnée (par la ligne de mot).

Le transistor de sélection TS d'une cellule a sa source reliée au drain du transistor à grille flottante TGF de la même cellule. Tous les transistors de sélection TS d'une même ligne de rang i sont reliées à la ligne de mot de même rang. Enfin, le transistor de sélection a son drain relié à une ligne de bit BLj de rang j pour la cellule de rang j. La ligne de bit de rang j relie les drains des transistors de sélection de toutes les cellules de la colonne de rang j.

Les lignes de bit BL0, BL1, ...BLj, ... sont reliées aux sorties d'un multiplexeur de colonne MUX qui permet de sélectionner une colonne de cellules dans le réseau.

Un compteur CPT, qui peut être incrémenté ou remis à zéro par le lecteur de carte à mémoire, sert à désigner une cellule C(i,j) déterminée du réseau de N lignes et P colonnes. Les sorties de poids fort du compteur sélectionnent une ligne de rang i parmi N, i croissant au fur et à mesure du comptage; les sorties de poids faible commandent le multiplexeur pour désigner successivement, au fur et à mesure du comptage, les diverses cellules d'une ligne. On peut ainsi, par incrémentation du compteur, parcourir la mémoire dans le sens des i croissants et dans le sens des j croissants pour i donné.

Le multiplexeur de colonne est relié par ailleurs à un amplificateur de lecture SA qui fournit à sa sortie S une information sur l'état d'une cellule désignée par une ligne de mot déterminée et une ligne de bit déterminée. Cette sortie S est accessible par un lecteur de carte pour assurer les échanges d'information entre la carte et le lecteur.

Le multiplexeur MUX permet par ailleurs d'appliquer sur une ligne de bit sélectionnée (par les poids faibles du compteur CPT) un potentiel nul pour l'effacement ou un potentiel élevé pour la programmation. Ces potentiels sont émis par un circuit d'écriture désigné par WRC.

Pour chaque ligne de rang i, sauf la première (i=1), on prévoit une cellule de mémoire non volatile auxiliaire. Cette cellule comprend un transistor à grille flottante auxiliaire, TGFA2 et TGFA3 pour les lignes 2 et 3, et un transistor de sélection auxiliaire TSA2 et TSA3 respectivement. De plus, un transistor de commande auxiliaire, TCA2 et TCA3 respectivement, est associé à chaque cellule auxiliaire.

Le transistor à grille flottante auxiliaire de la ligne de rang i a sa grille reliée à la source du transistor de commande auxiliaire de même rang, et son drain relié à la source du transistor de sélection auxiliaire de même rang. Les sources des transistors à grille flottante auxiliaires sont toutes reliées à un conducteur de commande AG2 qui joue un rôle analogue au conducteur AG1, c'est-à-dire qu'il peut être mis à la masse ou laissé flottant (mais indépendamment du conducteur AG1).

La grille du transistor de sélection auxiliaire de rang i et la grille du transistor de commande auxiliaire de rang i sont reliées au conducteur de ligne de mot de même rang i.

Les drains de tous les transistors de sélection auxiliaires sont tous reliés à un conducteur commun BLDEC qui joue le rôle d'une ligne de bit pour les cellules de mémoire auxiliaires comme on le détaillera ci-après.

Les drains de tous les transistors de commande auxiliaires sont reliés à un conducteur commun CG2 qui joue un peu le même rôle que le conducteur CG1 et qui peut être porté, indépendamment de CG1, à un potentiel de lecture (1 à 5 volts), de programmation (masse 0 volt), ou d'effacement (15 à 20 volts).

Enfin, la grille du transistor à grille flottante auxiliaire de rang i est reliée aux grilles de tous les transistors à grille flottante de la ligne de rang immédiatement inférieur i-1. C'est ainsi que la grille du transistor TGFA3 est reliée à toutes les grilles des transistors à grille flottante de la deuxième ligne; et la grille du transistor TGFA2 est reliée aux grilles des transistors à grille flottante de la première ligne.

Le conducteur BLDEC sert de ligne de bit pour les cellules non volatiles auxiliaires. En mode de lecture de l'état des cellules auxiliaires, il permet de transmettre à la sortie S du circuit intégré l'état de ces cellules. En mode de programmation d'une ligne de rang i, il transmet un niveau de tension de programmation (20 volts par exemple) de la même manière et en même temps qu'une ligne de bit sélectionnée par le multiplexeur transmet à une cellule de mémoire désignée un niveau de tension de programmation (20 volts). Enfin, en mode d'effacement, il est mis à la masse en même temps que les lignes de bit de la mémoire sont mises à la masse. Le conducteur BLDEC est représenté comme relié à l'amplificateur de lecture SA et au circuit d'écriture WRC .

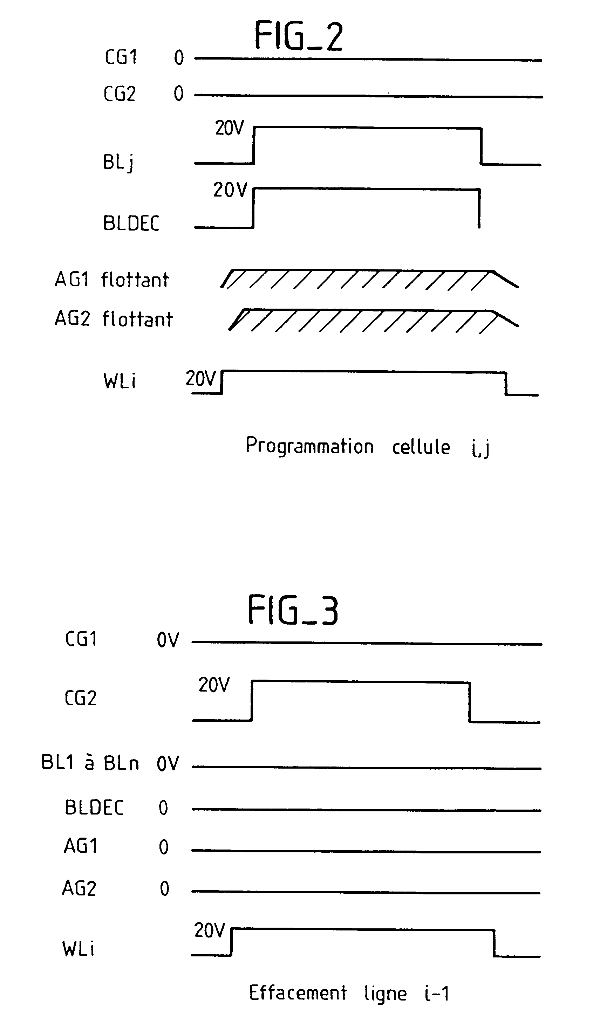

Les figures 2, 3, et 4 précisent les signaux qui doivent être appliqués sur les différents conducteurs pour effectuer une programmation, un effacement ou une lecture d'une cellule de mémoire.

Pour la programmation d'une cellule du réseau au carrefour de la ligne i et de la colonne j, on porte le conducteur CG1 à la masse, le conducteur AG1 est mis à un potentiel flottant, la ligne de mot WLi de la ligne désignée (i =1 à N) est portée à 20 volts par exemple pour rendre conducteurs à la fois le transistor de commande de rang i (TC1, TC2 ou TC3) et tous les transistors de sélection des cellules de la ligne i; la ligne de bit BLj de la cellule désignée est portée à une tension de programmation de 20 volts environ.

De même, pour la programmation d'une cellule auxiliaire de la ligne i, on porte CG2 à la masse, AG2 est flottant, le transistor de sélection auxiliaire de rang i (TSA2 ou TSA3) est passant ainsi que le transistor de commande auxiliaire de même rang (TCA2 ou TCSA3).

Comme la programmation d'une cellule de la ligne i du réseau doit être faite en même temps que la programmation de la cellule auxiliaire de la même ligne, on a représenté simultanément sur la figure 2 les diagrammes temporels correspondants.

Pour l'effacement d'une ligne de rang i-1 du réseau, la particularité de l'invention est qu'on n'utilise pas (contrairement à ce qu'on ferait habituellement) le conducteur CG1 (que l'on devrait porter à 20 volts en désignant par la ligne de mot de rang i-1 la ligne à effacer).

Ici, on va sélectionner artificiellement la ligne i alors qu'on souhaite effacer la ligne i-1. Et on va porter le conducteur CG2 à 20 volt et non le conducteur CG1. Le conducteur CG1 est mis à la masse ou flottant, ce qui va protéger la ligne sélectionnée de rang i contre un effacement. La ligne de mot de rang i est portée à un potentiel qui rend conducteur le transistor de commande de cette ligne i. Le transistor de commande de la ligne i-1 reste bloqué, ce qui empêche de porter à la masse les grilles des transistors à grille flottante de cette ligne i-1. Mais ces grilles reçoivent de l'autre côté la tension présente sur la source du transistor de commande auxiliaire de la ligne i. Ce dernier est conducteur du fait qu'il est commandé par la ligne de mot de rang i qui est sélectionnée; CG2 est à la tension d'effacement de 20 volts; cette tension se retrouve donc sur les grilles des transistors à grille flottante de toute la ligne i-1, en même temps d'ailleurs que sur la grille du transistor à grille flottante auxiliaire de la ligne i. Le conducteur AG1 et le conducteur AG2 sont à la masse. Tous ces transistors à grille flottante sont donc effacés.

La figure 3 résume cette procédure d'effacement des cellules de la ligne i-1 et de la cellule auxiliaire de rang i. On notera que, de même que toutes les lignes de bit du réseau sont portées à la masse pendant cette procédure d'effacement, de même la ligne de bit auxiliaire BLDEC est mise à la masse.

Pour la lecture, on doit choisir s'il faut lire l'état d'une cellule du réseau (on porte alors AG1 à la masse, sinon on le laisse flottant) ou au contraire l'état d'une cellule auxiliaire (on porte alors AG2 à la masse, sinon on le laisse flottant). Le conducteur de ligne de mot de rang i a sa ligne de mot portée à un potentiel qui rend les transistors de sélection et le transistor de commande de rang i conducteurs; le conducteur CG1 est porté à un potentiel de lecture de 1 à 5 volts environ, par exemple 2 volts; si AG1 est à la masse, c'est l'état d'une cellule de rang i,j désignée à la fois par la ligne de mot et par le multiplexeur de colonne qui est transmis à la sortie S; si au contraire AG2 est à la masse, c'est l'état de la cellule auxiliaire de rang i qui est transmis à la sortie.

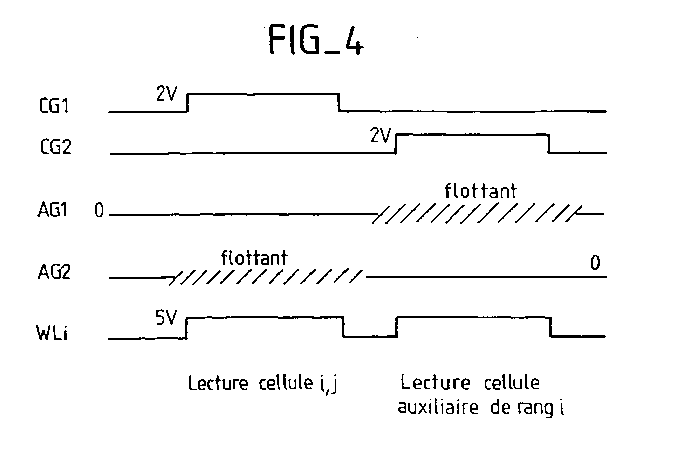

La figure 4 résume les signaux utilisés pour la lecture.

Le circuit intégré fonctionne de la manière suivante, sous le contrôle du lecteur de carte dont la fonction classique est de gérer le décomptage d'unités stockées dans la mémoire.

Le lecteur de carte peut classiquement exécuter les instructions suivantes :
- initialisation,
- incrémentation du compteur d'adresse CPT pour parcourir la mémoire en désignant successivement les cellules de la mémoire dans l'ordre des cellules sur une ligne et dans l'ordre des lignes successives de 1 à N.
- lecture de la cellule désignée;
- programmation d'une cellule désignée par le compteur d'adresse;
- effacement de toute la ligne désignée par les poids forts du compteur d'adresse.

De plus, pour mettre en oeuvre l'invention, le lecteur devra pouvoir donner une instruction spécifique de lecture de la cellule de mémoire auxiliaire de la ligne désignée par les poids forts du compteur d'adresse. Cette instruction est différente de l'instruction de lecture d'une cellule de mémoire quelconque du réseau. Elle correspond en effet à des potentiels différents comme on l'a expliqué à propos de la figure 4.

Lors de l'insertion d'une carte, le lecteur exécute d'abord une procédure de vérification de l'état des cellules auxiliaires. Pour cela, il initialise le compteur et l'incrémente en effectuant une lecture des cellules auxiliaires de la mémoire après chaque incrémentation de poids fort, c'est-à-dire à chaque nouveau rang i. L'instruction spécifique de lecture donnée à chaque fois met le conducteur AG2 et non pas AG1 à la masse.

Dans le cas général, toutes les cellules auxiliaires sont dans l'état effacé, car si une d'elles est programmée, c'est qu'il y a eu interruption anormale d'une phase de décomptage. On reviendra plus loin sur la suite de la procédure de vérification dans le cas où une cellule auxiliaire programmée est détectée.

Après la procédure de vérification, le lecteur peut exécuter une procédure de décomptage d'une unité. Cette procédure est une procédure récurrente qui commence par une réinitialisation du compteur d'adresse et une recherche de la première cellule effacée en balayant la mémoire ligne par ligne à partir de la première (poids le plus faible). Pour cela il exécute successivement des opérations de lecture et incrémentation alternées. Il s'agit maintenant d'une lecture des cellules du réseau, donc c'est à chaque fois le conducteur AG1 qui est mis à zéro et non AG2.

Lorsqu'une cellule effacée (cellule de rang i,j) est trouvée, le compteur d'adresse reste figé et le lecteur de carte exécute une séquence comprenant une étape de programmation de la cellule désignée suivie d'une étape d'effacement de ligne sans modifier l'état du compteur; la procédure s'arrête toutefois avant l'étape d'effacement si la cellule désignée appartient à la première ligne. Si elle appartient à une autre ligne, l'effacement de ligne est effectué et la procédure récurrente est recommencée.

L'instruction de programmation telle que décrite ci-dessus fournit les potentiels suivants : BLj = 20 volts, CG1 = CG2 = 0 volt, AG1 et AG2 flottants, BLDEC = 20 volts, WLi = 20 volts. Cela programme à la fois la cellule de rang i,j et la cellule auxiliaire de rang i.

Deux cas sont possibles : ou bien le compteur désigne la première ligne (i=1), et la procédure de décomptage d'une unité est terminée. Ou bien il désigne une autre ligne (i>1) et la procédure doit être poursuivie par une instruction d'effacement de ligne.

On exécute alors cette instruction d'effacement de ligne, sans changer l'état du compteur, ce qui va provoquer non pas l'effacement de la ligne désignée i, mais, comme expliqué ci-dessus, l'effacement simultané de toutes les cellules de la ligne i-1 ainsi que de la cellule auxiliaire de rang i. L'instruction d'effacement fournit en effet simultanément les potentiels suivants : CG1=0, CG2=20v, WLi=20v, BL1=BL2=...,etc.=BLDEC=0, AG1=AG2=0.

Une procédure de décomptage est alors recommencée : réinitialisation du compteur, balayage de la mémoire pour trouver la première cellule effacée, etc. La procédure de décomptage est effectuée de manière récurrente jusqu'à ce que la première cellule effacée trouvée soit bien dans la première ligne. Cette cellule est programmée et la procédure récurrente se termine.

Si on suppose maintenant que la vérification initiale, faite par le lecteur lors de la mise sous tension de la carte, fait apparaître une cellule auxiliaire de rang i à l'état programmé, le lecteur doit déclencher l'opération d'effacement de la ligne de rang i-1 avant l'exécution de toute procédure de décomptage.

Le compteur reste figé à la position qui désigne cette ligne i; l'instruction d'effacement telle que décrite ci-dessus est exécutée sans changer l'état du compteur, ce qui conduit à l'effacement de la ligne i-1 et non la ligne i, et à l'effacement simultané de la cellule auxiliaire de rang i. Ceci ramène la mémoire à un compte qui est celui qu'elle aurait dû avoir si la procédure récurrente n'avait pas été interrompue anormalement. On peut alors effectuer la procédure de décomptage récurrente telle que décrite ci-dessus.

En pratique, il n'y a pas lecture de la cellule auxiliaire par le lecteur. Ceci est dû à des questions de compatibilité avec des dispositifs existants qui ne sont pas munis du système de l'invention. Dans ce cas la lecture de la cellule mémoire et de la cellule auxiliaire a lieu pour chaque instruction de lecture externe. La chronologie des signaux montrés sur la figure 4 se produit alors à chaque impulsion d'horloge. Les résultats de cette lecture sont alors stockés dans deux registres distincts, un de ces registres représentant l'état de la cellule mémoire, l'autre de la cellule auxiliaire. Le lecteur ne peut lire que l'état de la cellule mémoire (sauf pendant le test du circuit). La procédure de détection d'une cellule auxiliaire non effacée est alors la suivante:
1. mise sous tension,
2. lecture de la mémoire jusqu'à la première ligne du compteur,
3. exécution d'une instruction d'effacement de la ligne. Si le problème de coupure de courant a eu lieu, la cellule auxiliaire correspondante est à zéro. Le circuit autorisera dans ce cas l'effacement de la ligne suivante (effacement boulier avec CG2=20v, CG1=0 ou flottant, AG1=AG2=0). Dans le cas contraire rien ne change.
4. Incrémentation de la ligne du compteur.
5. Exécution de l'instruction d'effacement (comme au point 3).

Ainsi de suite jusqu'à la dernière ligne.

Avec cette procédure le circuit autorisera l'effacement de la ligne qui n'a pas été effacée correctement sans indiquer au lecteur le numéro de la ligne. Ce n'est seulement qu'après que cet effacement a eu lieu que le lecteur saura dire de quelle ligne il s'agissait. Dans certains circuits l'instruction d'effacement ne peut être effectuée qu'après une instruction de programmation. Dans ce cas lors de la mise sous tension le lecteur doit se positionner sur une cellule programmée (à 0) de chaque ligne du compteur pour effectuer l'effacement. Ainsi il ne va pas programmer a "0" un autre bit du compteur. Si une ligne ne comporte pas de "0", le lecteur n'exécute pas d'effacement. Celui-ci serait inutile car forcément il n'y aurait pas eu de problème de coupure de courant.

## Revendications

1. Circuit intégré pour carte à mémoire, comprenant
- une mémoire non volatile organisée en réseau de N zones de P cellules (C(i,j))
- des moyens de programmation sélective d'une cellule de rang i,j de la mémoire, i désignant le rang de la zone et j le rang de la cellule dans la zone,
- des moyens d'effacement sélectif de toutes les cellules d'une zone sélectionnée,
caractérisée en ce que la mémoire comporte, associée à chaque zone de rang i, une seule cellule de mémoire auxiliaire non volatile (TGFA2, TGFA3) qui est programmée en même temps que n'importe quelle cellule de la zone de rang i et qui est effacée en même temps que les cellules de la zone de rang i-1.

2. Circuit intégré selon la revendication 1, comportant en outre un compteur d'adresse de cellules (CPT) dont les poids forts permettent de sélectionner une zone de rang i et les poids faibles une cellule de rang j dans la zone sélectionnée, caractérisé en ce qu'il comporte des circuits (TCA2, TCA3, TC1, TC2, TC3) commandés par les sorties de poids fort du compteur pour que, lorsque la zone de rang i est sélectionnée, des potentiels de programmation d'une cellule de la zone de rang i et de la cellule auxiliaire de rang i puissent être appliqués à ces cellules, et pour que, toujours lorsque la ligne i est sélectionnée, des potentiels d'effacement de la ligne i-1 (i>1) et des potentiels d'effacement de la cellule auxiliaire de rang i puissent être appliqués.

3. Circuit intégré selon l'une des revendications 1 et 2, caractérisé en ce que
- les cellules de mémoire non volatiles du réseau et les cellules auxiliaires comportent chacune un transistor de sélection (TS) et un transistor à grille flottante (TGF),
- les transistors à grille flottante des cellules d'une zone de rang i-1 du réseau ayant une grille de commande reliée à la grille de commande du transistor à grille flottante de la cellule auxiliaire de la zone i,
- les sources des transistors à grille flottante du réseau étant reliées à un premier conducteur commun (AG1) et les sources des transistors à grille flottante auxiliaires étant reliées à un deuxième conducteur commun (AG2) indépendant du premier.

4. Circuit intégré selon la revendication 3, caractérisé en ce que les grilles de commande des transistors à grille flottante de la zone i sont reliées par un transistor de commande de rang i à un troisième conducteur commun (CG1) permettant d'appliquer un potentiel de lecture, d'effacement, ou de programmation aux cellules de rang i, et en ce que la grille de commande du transistor à grille flottante auxiliaire de rang i est reliée par un transistor de commande auxiliaire (TCA2, TCA3) de rang i à un quatrième conducteur commun (CG2) permettant d'appliquer un potentiel de lecture, programmation ou effacement à la cellule auxiliaire de rang i.

5. Circuit intégré selon la revendication 4, caractérisé en ce que le transistor de commande de rang i et le transistor de commande auxiliaire de rang i sont commandés par une ligne de mot de rang i.

6. Circuit intégré selon l'une des revendications 3 à 5, caractérisé en ce que les transistors de sélection correspondant à une zone i du réseau sont commandés par une ligne de mot de rang i, et relient les drains des transistors à grille flottante d'un même rang j à une même ligne de bit de rang j, en ce que le transistor de sélection de la cellule auxiliaire de rang i est commandé par la ligne de mot de rang i et relie le transistor à grille flottante de cette cellule auxiliaire à une ligne de bit auxiliaire (BLDEC) commune à toutes les cellules auxiliaires, et en ce que sur cette ligne de bit auxiliaire est appliqué en mode de programmation ou effacement le même potentiel que sur une ligne de bit correspondant à une cellule à programmer ou effacer dans le réseau.

7. Circuit intégré selon la revendication 6, caractérisé en ce que la ligne de bit auxiliaire est reliée à une sortie (S) du circuit pour lire l'état des cellules auxiliaires.

8. Procédé de décomptage d'unités de compte à partir d'une carte à mémoire contenant une mémoire non volatile organisée en réseau de N zones de P cellules, et un compteur d'adresse de cellules du réseau (CPT), chaque zone ayant un poids qui est P fois le poids de la zone de rang immédiatement inférieur, ce procédé consistant, pour décompter une unité, à exécuter la procédure récurrente suivante :
- incrémentation du compteur et lecture de l'état d'une cellule désignée jusqu'à trouver une première cellule effacée en parcourant la mémoire dans l'ordre des zones de poids croissant,
- programmation de la première cellule effacée trouvée sans incrémenter le compteur, et, si la première cellule n'est pas située dans la zone de rang le plus faible:
- programmation d'une cellule de mémoire auxiliaire non volatile associée à la zone dans laquelle se situe la première cellule effacée en même temps qu'on programme la première cellule effacée,
- effacement de la zone de rang immédiatement inférieur à celui de la cellule trouvée,
- effacement de cette cellule auxiliaire, en même temps qu'on efface la zone de rang immédiatement inférieur, et recommencement de la procédure récurrente,
caractérisé en ce que les étapes d'effacement sont effectuées après les étapes de programmation, si la première cellule désignée par le compteur n'appartient pas à la zone de poids le plus faible,
sans changer l'état du compteur.

9. Procédé selon la revendication 8, caractérisé en ce qu'il comprend les étapes préliminaires suivantes avant toute procédure de décomptage, à la mise sous tension de la carte à mémoire :
- recherche d'une cellule auxiliaire programmée, et
- effacement simultané de cette cellule et de la zone de rang immédiatement inférieur.

10. Carte à mémoire utilisant un circuit intégré selon l'une des revendications 1 à 7.

## Patentansprüche

1. Integrierte Schaltung für eine Speicherkarte, mit
- einem in Form eines Gitters mit N Abschnitten zu P Zellen (C(i, j)) organisierten nichtflüchtigen Speicher,
- Programmiermitteln zum selektiven Programmieren einer Zelle mit dem Rang i, j des Speichers, wobei i den Rang des Abschnitts und j den Rang der Zelle in dem Abschnitt bezeichnet,
- Löschmitteln zum selektiven Löschen aller Zellen eines gewählten Abschnitts,
dadurch gekennzeichnet, daß der Speicher zu jedem Abschnitt mit Rang i eine einzelne nichtflüchtige Hilfsspeicherzelle (TGFA2, TGFA3) umfaßt, die zur gleichen Zeit wie jede beliebige Zelle des Abschnitts mit dem Rang i programmiert wird und zur gleichen Zeit wie die Zellen des Abschnitts mit dem Rang i-1 gelöscht wird.

2. Integrierte Schaltung nach Anspruch 1, mit einem Zellenadressenzähler (CPT), dessen höherwertige Stellen es ermöglichen, einen Abschnitt mit Rang i auszuwählen und dessen geringerwertige Stellen es ermöglichen, eine Zelle mit Rang j im gewählten Abschnitt auszuwählen, dadurch gekennzeichnet, daß er Schaltungen (TCA2, TCA3, TC1, TC2, TC3) umfaßt, die durch die höherwertigen Ausgänge des Zählers gesteuert werden, so daß, wenn der Abschnitt mit Rang i ausgewählt worden ist, Potentiale zum Programmieren einer Zelle des Abschnitts mit Rang i und der Hilfszelle mit Rang i an diese Zellen angelegt werden können, und daß ferner, wenn die Linie i ausgewählt ist, Löschpotentiale zum Löschen der Linie i-1 (i>1) und Löschpotentiale zum Löschen der Hilfszelle mit Rang i angelegt werden können.

3. Integrierte Schaltung nach einem der Ansprüche 1 oder 2, dadurch gekennzeichnet, daß
- die nichtflüchtigen Speicherzellen des Gitters und die Hilfszellen jeweils einen Auswahltransistor (TS) und einen Transistor mit schwebendem Gate (TGF) umfassen,
- wobei die Transistoren mit schwebendem Gate der Zellen eines Abschnitts mit Rang i-1 des Gitters ein Steuergate haben, das mit dem Steuergate des Transistors mit schwebendem Gate der Hilfszelle des Abschnitts i verbunden ist,
- die Sources der Transistoren mit schwebendem Gate des Gitters mit einem ersten gemeinsamen Leiter (AG1) und die Sources der Hilfstransistoren mit schwebendem Gate mit einem zweiten, vom ersten unabhängigen gemeinsamen Leiter (AG2) verbunden sind.

4. Integrierte Schaltung nach Anspruch 3, dadurch gekennzeichnet, daß die Steuergates der Transistoren mit schwebendem Gate des Abschnitts i durch einen Steuertransistor mit Rang i mit einem dritten gemeinsamen Leiter (CG1) verbunden sind, der es ermöglicht, ein Lese-, Lösch- oder Programmierpotential an die Zellen mit Rang i anzulegen, und daß das Steuergate des Hilfstransistors mit schwebendem Gate mit Rang i über einen Hilfssteuertransistor (TCA2, TCA3) mit Rang i mit einem vierten gemeinsamen Leiter (CG2) verbunden ist, der es ermöglicht, ein Lese-, Programmier- oder Löschpotential an die Hilfszelle mit Rang i anzulegen.

5. Integrierte Schaltung nach Anspruch 4, dadurch gekennzeichnet, daß der Steuertransistor mit Rang i und der Hilfssteuertransistor mit Rang i über eine Wort leitung mit Rang i gesteuert werden.

6. Integrierte Schaltung nach einem der Ansprüche 3 bis 5, dadurch gekennzeichnet, daß die einem Abschnitt i des Gitters entsprechenden Auswahltransistoren über eine Wortleitung mit Rang i gesteuert werden und die Drains der Transistoren mit schwebendem Gate mit gleichem Rang j mit ein und derselben Bitleitung mit Rang j verbinden, und daß der Auswahltransistor der Hilfszelle mit Rang i über die Wortleitung mit Rang i gesteuert wird und den Transistor mit schwebendem Gate dieser Hilfszelle mit einer allen Hilfszellen gemeinsamen Hilfsbitleitung (BLDEC) verbindet, und daß im Programmier- oder im Löschmodus an diese Hilfsbitleitung das gleiche Potential angelegt wird, wie an eine Bitleitung, die einer zu programmierenden oder zu löschenden Zelle des Gitters entspricht.

7. Integrierte Schaltung nach Anspruch 6, dadurch gekennzeichnet, daß die Hilfsbitleitung mit einem Ausgang (S) der Schaltung zum Lesen des Zustands der Hilfszellen verbunden ist.

8. Verfahren zum Abzählen von Zähleinheiten anhand einer Speicherkarte mit einem in Form eines Gitters mit N Abschnitten zu P Zellen organisierten nichtflüchtigen Speicher und einem Adreßzähler (CPT) für die Zellen des Gitters, wobei jeder Abschnitt ein Gewicht gleich dem P-fachen des Gewichts des Abschnitts mit nächstniedrigerem Rang hat, und das daraus besteht, zum Abzählen einer Einheit die folgende rekursive Prozedur durchzuführen:
- Inkrementieren des Zählers und Lesen des Zustands einer bezeichneten Zelle, bis eine erste gelöschte Zelle gefunden wird, wobei der Speicher in Richtung zunehmender Gewichte durchlaufen wird,
- Programmieren der ersten gefundenen gelöschten Zelle, ohne den Zähler zu inkrementieren, und, wenn diese erste Zelle nicht im Abschnitt mit niedrigstem Rang liegt:
- Programmieren einer dem Abschnitt, in dem die erste gelöschte Zelle liegt, zugeordneten nichtflüchtigen Hilfsspeicherzelle zur gleichen Zeit, zu der die erste gelöschte Zelle programmiert wird,
- Löschen des Abschnitts mit bezogen auf den Rang der gefundenen Zelle nächstniedrigerem Rang,
- Löschen der Hilfsspeicherzelle zur gleichen Zeit, zu der der Abschnitt mit nächstniedrigerem Rang gelöscht wird, und Neubeginnen der rekursiven Prozedur,
dadurch gekennzeichnet, daß wenn die vom Zähler bezeichnete erste Zelle nicht zum Abschnitt mit geringstem Gewicht gehört, die Löschschritte nach den Programmierschritten durchgeführt werden, ohne den Zustand des Zählers zu ändern.

9. Verfahren nach Anspruch 8, dadurch gekennzeichnet, daß es vor jeglicher Abzählprozedur folgende Vorabschritte beim Unterspannungsetzen der Speicherkarte umfaßt:
- Suchen einer programmierten Hilfszelle und
- gleichzeitiges Löschen dieser Zelle und des Abschnitts mit nächstniedrigerem Rang.

10. Speicherkarte, die eine integrierte Schaltung nach einem der Ansprüche 1 bis 7 verwendet.

## Claims

1. Integrated circuit for a memory card comprising
- a non-volatile memory organised in a network of N zones of P cells (C(i,j,))
- means for selectively programming a cell ranked i, j of the memory, where i denotes the rank of the zone and j the rank of the cell within the zone,
- means for selectively erasing all the cells of a selected zone,
characterised in that the memory has, associated with each zone of rank i, a single auxiliary non-volatile memory cell (TGFA2, TGFA3) which is programmed simultaneously with any cell of the zone of rank i and which is erased simultaneously with the cells in the zone of rank i-1.

2. Integrated circuit as claimed in claim 1, which also has a cell address counter (CPT), the high weightings of which enable a zone of rank i to be selected and the low weightings a cell of rank j in the selected zone, characterised in that it has circuits (TCA2, TCA3, TC1, TC2, TC3) controlled by high weighting outlets of the counter so that when the zone of rank i is selected, the programming potentials of a cell of rank i of the zone and the auxiliary cell of rank i can be applied to these cells and so that, whilst the line i is still selected, the erasing potentials of the line i-1 (i>1) and the erasing potentials of the auxiliary cell of rank i can be applied.

3. Integrated circuit as claimed in one of claims 1 and 2, characterised in that
- the non-volatile memory cells of the network and the auxiliary cells each have a specific transistor (TS) and a floating gate transistor (TGF),
- the floating gate transistors of the cells of a zone of rank i-1 have a control gate linked to the control gate of the floating gate transistor of the auxiliary cell of the zone i,
- the sources of the auxiliary floating gate transistors of the network are linked to a first common conductor (AG1) and the sources of the auxiliary floating gate transistors are linked to a second common conductor (AG2) independent of the first.

4. Integrated circuit as claimed in claim 3, characterised in that the control gates of the floating gate transistors of zone i are linked by a control transistor of rank i to a third common conductor (CG1) allowing a reading, erasing or programming potential to be applied to the cells of rank i and the control gate of the auxiliary floating gate transistor of rank i is linked by an auxiliary control transistor (TCA2, TCA3) of rank i to a fourth common conductor (CG2) allowing a reading, programming or erasing potential to be applied to the auxiliary cell of rank i.

5. Integrated circuit as claimed in claim 4, characterised in that the control transistor of rank i and the auxiliary control transistor of rank i are controlled by a word line of rank i.

6. Integrated circuit as claimed in one of claims 3 to 5, characterised in that the specific transistors corresponding to a zone i of the network are controlled by a word line of rank i and link the drains of the floating gate transistors of a same rank j to a same bit line of rank j, the specific transistor of the auxiliary cell of rank i is controlled by the word line of rank i and links the floating gate transistor of this auxiliary cell to an auxiliary bit line (BLDEC) common to all the auxiliary cells, and the same potential is applied to this auxiliary bit line in programming or erasing mode as on a bit line corresponding to a cell to be programmed or erased in the network.

7. Integrated circuit as claimed in claim 6, characterised in that the auxiliary bit line is linked to an output (S) of the circuit so as to read the status of the auxiliary cells.

8. Method of deducting tally units from a memory card having a non-volatile memory organised in a network of N zones of P cells and a counter for the cell addresses in the network (CPT), each zone having a weighting which is P times the weighting of the zone of the rank immediately below, this method consisting of executing the following recurrent procedure in order to deduct a unit:
- incrementing the counter and reading the status of a designated cell until a first erased cell is found by searching the memory in the order of zones of increasing weighting,
- programming the first erased cell found without incrementing the counter and, if the first cell is not located in the zone of the lowest rank:
- programming a non-volatile auxiliary memory cell associated with the zone in which the first erased cell is located and simultaneously programming the first erased cell,
- erasing the zone of the rank immediately below that of the cell found,
- erasing this auxiliary cell at the same time as the zone of the rank immediately below is erased and recommencing the recurrent procedure,
characterised in that the erasing steps are performed after the programming steps if the first cell designated by the counter does not belong to the zone of the lowest weighting, without changing the status of the counter.

9. Method as claimed in claim 8, characterised in that it consists of the following preliminary steps before any deduction procedure, once voltage has been applied to the memory card:
- searching for a programmed auxiliary cell and
- simultaneously erasing this cell and the zone of the rank immediately below.

10. Memory card using an integrated circuit as claimed in one of claims 1 to 7.
